# EUROPÄISCHE PATENTSCHRIFT

(11) **EP 0 405 077 B1**
(45) Veröffentlichungstag und Bekanntmachung des Hinweises auf die Patenterteilung: **20.12.1995**
(21) Anmeldenummer: 90107195.1
(22) Anmeldetag: 14.04.1990
(51) Int. Cl.: H01Q 17/00, H01Q 15/00, H05K 9/00

(54) **Fassadenaufbau von Hochbauten**
Façade cover for rising structures
Revêtement de façade pour constructions élevées

(30) Priorität: 06.06.1989 DE 3918383
(43) Veröffentlichungstag der Anmeldung: 02.01.1991
(73) Patentinhaber: Daimler-Benz Aerospace Aktiengesellschaft, 81663 München (DE)
(72) Erfinder: Frye, Andreas, Dr., D-2800 Bremen 1 (DE)

(56) Entgegenhaltungen:
- DE-B- 1 011 015
- IEEE TRANSACTIONS ON BROADCASTING. vol. BC-25, no. 4, Dezember 1979, NEW YORK US Seiten 143 - 146; Takizawa: "Reduction of ghost signal by use of magnetic absorbing material on walls"
- PATENT ABSTRACTS OF JAPAN vol. 7, no. 208 (E-198)(1353) 14 September 1983,& JP-A-58 104506 (TOKYO DENKI) 22 Juni 1983,
- NTZ NACHRICHTECHNISCHE ZEITSCHRIFT. vol. 41, no. 5, Mai 1988, BERLIN DE Seiten 280-283 ; Dominik et al.: "Hochfrequenz-absorbierende Materialien"

## Beschreibung

Die Erfindung betrifft einen Fassadenaufbau von Hochbauten mit einer auf der Außenseite einer Wand angebrachten reflektierenden Schicht.

Aus der Zeitschrift IEEE Transactions on Broadcasting, Band BC-25, Dezember 1979, Seiten 143 - 146 ist eine plattenförmige Fassadenverkleidung bekannt geworden, die eine Ferritschicht als Fassadenaußenteile aufweist. Eine derartige Verkleidung ist zur Absorption von UKW-Strahlung geeignet, nicht jedoch für elektromagnetische Strahlung im Radarfrequenzbereich.

Für den Radarfrequenzbereich ist in der Zeitschrift NTZ, Nachrichtentechnische Zeitschrift, Band 41, Nr. 5, Mai 1988, Seiten 280 - 283 ein Resonanzabsorber (Salisbury-Screen-Absorber) vorgeschlagen worden, der im Abstand von einem Viertel der Betriebswellenlänge vor einer reflektierenden Metallplatte eine Widerstandsschicht mit einem Flächenwiderstand von vorzugsweise 377 Ohm/Quadrat aufweist. Es wird jedoch kein Hinweis gegeben, wie die Problematik der Integration eines derartigen Absorbers in den Fassadenaufbau eines Gebäudes zu lösen ist.

Die bisher bekannt gewordenen Fassadenaufbauten sind nicht geeignet, die baubehördlichen und architektonischen Anforderungen an das äußere Erscheinungsbild des Gebäudes zu erfüllen. Die bekannten Absorptionselemente bestimmen vielmehr aufgrund ihrer physikalischen Funktionsweise das optische Erscheinungsbild der mit ihnen verkleideten Gebäude.

Der Erfindung liegt deshalb die Aufgabe zugrunde, das Prinzip des Salisbury-Screen-Absorbers für einen Fassadenaufbau anwendbar zu machen, so daß die Reflexion elektromagnetischer Strahlung im Radarfrequenzbereich über einen breiten Einfallswinkelbereich und auch bei gekrümmten Fassadenflächen unterdrückt wird und gleichzeitig handelsübliche witterungsbeständige Fassadenbaustoffe verwendet werden können, um die bisher üblichen Anforderungen zu erfüllen.

Diese Aufgabe wird erfindungsgemäß durch die im kennzeichnenden Teil des Hauptanspruches wiedergegebenen Merkmale gelöst.

Durch diese Merkmalskombination ist es möglich, durch eine geeignete Auswahl der physikalischen Parameter der Widerstandsschicht eine optimale Reflexionsunterdrückung für vorgebbare Trägermaterialien zu gewährleisten. Die Reflektions- und Absorptionseigenschaft der Kombination aus Träger und Widerstandsschicht wird wesentlich durch die Widerstandsschicht bestimmt.

Mit einem derartigen Fassadenaufbau können insbesondere auch Gebäude verkleidet werden, die große geometrische Abmessungen und damit auch großflächige ebene Konturen aufweisen. Insbesondere ist an eine Verkleidung von derartigen Bauwerken gedacht, die in unmittelbarer Nähe von Richtfunkstrecken oder Flugsicherungsanlagen (Airport Surveillance Radar) angeordnet sind. Durch die Verkleidung dieser Gebäude werden Reflexionen vermieden, die die Übertragungsqualität der Richtfunkstrecken bzw. die Aufgaben einer Flugsicherungsanlage zur Flugzeugidentifikation empfindlich beeinträchtigen würden.

An der Widerstandsschicht werden die in einem bestimmten Winkelbereich auftreffenden Wellenanteile reflektiert, während der transmittierende Wellenanteil nach Durchlaufen der Abstandsschicht von der reflektierenden Grundschicht zurückgeworfen und mit dem an der Widerstandsschicht nach außen reflektierten Wellenanteil zur Interferenzauslöschung kommt und somit eine Reflexion ausschaltet.

Durch die Ausbildung der reflektierenden Grundschicht als Metallfolie oder als ein engmaschiges Metallgitter wird im Bereich der Oberfläche des verkleideten Gebäudes eine definierte Reflexionsebene geschaffen, die diffuse Reflexionen im Bereich von einer Stahlbewehrung der Gebäudewandung oder im Bereich von sonstigen Einschüssen vermeidet und somit definierte Reflexions-\und Absorptionsverhältnisse gewährleistet.

Die Widerstandsschicht ist dabei entweder auf oder in dem als Fassadenaußenschale ausgebildeten Träger in Form von Baustoff-Platten angebracht. Letztere bestehen aus einem keramischen Material oder Glas. Alternativ ist vorgesehen, einen Träger aus einem Schichtpreßstoff aus mit Kunstharzen imprägnierten verpreßten Zellulosefäden oder aus einem Faserverbundbaustoff zu verwenden.

Zur Ausbildung der Widerstandsschicht ist vorgesehen, daß die Widerstandsschicht aus einem mit Aluminium bedampften Vlies gebildet ist. Alternativ werden durch ein Vlies aus elektrisch leitfähigen Fasern oder durch ein Vlies mit inkorporiertem Ruß Widerstandsschichten ausgebildet. Ferner besteht eine weitere Alternative darin, daß die Widerstandsschicht innerhalb eines Trägers durch einen Film aus elektrisch und/oder magnetisch leitfähigen Materialpartikeln gebildet ist.

Zur Verbesserung der Eigenschaften des Fassadenaufbaues wird vorgeschlagen, daß zwischen der reflektierenden Grundschicht und der Widerstandsschicht eine Abstandsschicht durch ein Sandwich-Element gebildet ist. Dazu wird vorgeschlagen, daß zwischen der reflektierenden Grundschicht und der Widerstandsschicht eine Abstandsschicht aus mehreren Teilelementen gebildet ist und zwischen den Teilelementen eine zusätzliche Widerstandsschicht und/oder eine stark reflektierende zusätzliche Schicht angeordnet ist.

Ferner ist zur Ausbildung einer erfindungsgemäßen Anordnung vorgesehen, daß auf die reflektierende Schicht zusätzlich eine Metallfolie bzw. ein engmaschiges Metallgitter aufgebracht ist.

In der Zeichnung sind Ausführungsbeispiele der Erfindung schematisch dargestellt. Es zeigen:
Fig. 1 einen Schnitt durch einen Fassadenaufbau mit einer einteiligen Wärmedämmschicht und
Fig. 2 einen Schnitt gemäß Figur 1 mit einer mehrteiligen Wärmedämmschicht.

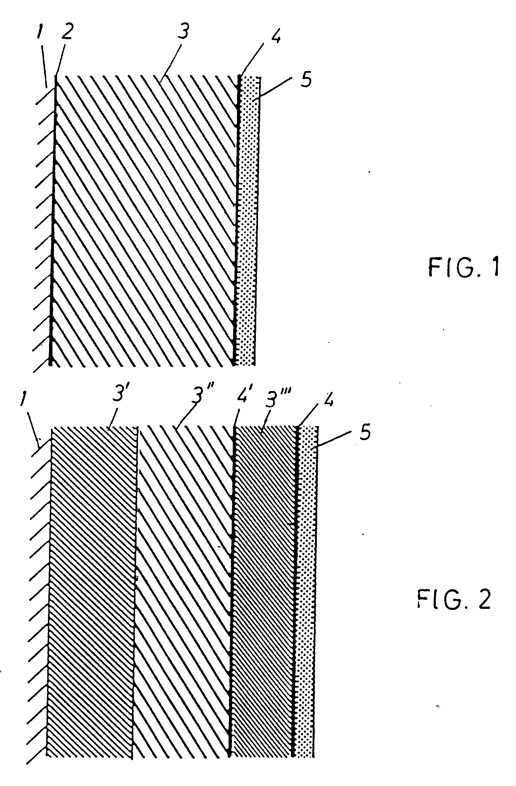

Bei der dargestellten Abbildung gemäß Fig. 1 ist auf einer reflektierenden Gebäudewand aus Stahlbeton (1) eine zusätzliche Metallfolie (2) als Reflexionsschicht aufgebracht. Danach folgt eine Abstandsschicht (3) aus einem elektrischen Nichtleiter, wie geschäumtem Glas oder Kunststoff, beispielsweise Polyurethan bzw. Mineral- oder Steinwolle, die eine Wärmedämmung bildet. Auf diese Abstandsschicht (3) als Sandwich-Element folgt eine Widerstandsschicht (4), die auf dem Träger (5) als Fassadenaußenschale angeordnet ist. Der Träger (5) ist aus einem Material, wie beispielsweise Keramik, mit einer geringen Transmissionsdämpfung der auftreffenden Wellen gebildet. Die Widerstandsschicht (4) ist derart konzipiert, daß sie einen Flächenwiderstand zwischen 300 und 1200 Ohm/Quadrat aufweist. Ebensogut ist es möglich, unter Verzicht auf eine besondere Wärmedämmschicht (3) den Träger (5) zusammen mit der Widerstandsschicht (4) mit Hilfe von Abstandhaltern vor der Reflexionsschicht (2) anzubringen.

Gemäß Fig. 2 ist ein weiteres Ausführungsbeispiel dargestellt, wobei abweichend von der Fig. 1 die Abstandsschicht (3) durch mehrere Teilelemente (3′, 3′′ und 3′′′) gebildet ist, zwischen denen sich auch eine zusätzliche Widerstandsschicht (4) befindet.

Selbstverständlich ist es möglich, eine entsprechende Reflexionsschicht (2) auch als zusätzliche Schicht zwischen den Teilelementen (3', 3" und 3"') anzuordnen.

Eine entsprechende Reflexionsunterdrückung läuft gemäß Fig. 1 wie folgt ab:

Nach Auftreffen einer Radarwelle von 1,1 GHz auf den Träger (5), dessen Reflexionscharakter durch die Widerstandsschicht (4) bestimmt wird, werden Wellenanteile reflektiert.

Die nichtreflektierten Anteile durchlaufen die Zwischenschicht (3), die nicht mehr als 10% der Wellenanteile absorbiert und treffen auf die reflektierende Schicht (2). Der Abstand der reflektierenden Schicht (2) von der Widerstandsschicht (4) und dem Träger (5) beträgt etwa 1/4 der Wellenlänge, die die Welle in Ausbreitungsrichtung hat. Bei senkrechtem Einfall der Radarwelle von ca. 1,0 GHz ergibt sich ein Abstand von 35 bis 55 mm.

Der von der reflektierenden Schicht (2) zurückgeworfene Wellenanteil erfährt aufgrund der Phasenverschiebung gegenüber dem an der Widerstandsschicht (4) reflektierten Wellenanteil eine Interferenzauslöschung, so daß die Reflexion der Fassade weitgehend unterdrückt wird.

Auf diese Weise wird eine Reflexionsdämpfung erzielt, die im Frequenzbereich von 1,0 GHz bis 1,1 GHz eine tatsächliche Reflexion R < -20 dB, d.h. geringer als 1 %, gegenüber der einfallenden Energie realisiert.

## Patentansprüche

1. Fassadenaufbau von Hochbauten mit einer auf der Außenseite einer Wand (1) angebrachten reflektierenden Schicht (2), **gekennzeichnet durch** folgende Merkmale:
a) eine elektrische Widerstandsschicht (4) mit einem Flächenwiderstand im Bereich von 300 bis 1200 Ω/□ ist im Abstand von etwa einem Viertel der Betriebswellenlänge (λ) zur reflektierenden Schicht (2) angeordnet;
b) die Widerstandsschicht (4) ist auf oder in einem als Fassadenaußenschale ausgebildeten Träger (5) angeordnet, der eine geringe Transmissionsdämpfung aufweist;
c) der Träger (5) besteht aus einem Baustoff und
d) zwischen der reflektierenden Schicht (2) und der Widerstandsschicht (4) oder dem Träger (5) ist eine wärmedämmende Abstandsschicht (3) vorgesehen.

2. Fassadenaufbau nach Anspruch 1, **dadurch gekennzeichnet,** daß der Träger (5) aus einem keramischen Material gebildet ist.

3. Fassadenaufbau nach Anspruch 1, **dadurch gekennzeichnet**, daß der Träger (5) durch einen Schichtpreßstoff aus mit Kunstharzen imprägnierten verpreßten Celluloseflächen gebildet ist.

4. Fassadenaufbau nach Anspruch 1, **dadurch gekennzeichnet,** daß der Träger (5) aus einem Faserzement-Baustoff gebildet ist.

5. Fassadenaufbau nach einem der Ansprüche 1 bis 4, **dadurch gekennzeichnet**, daß die Widerstandsschicht (4) aus einem mit Aluminium bedampften Vlies gebildet ist.

6. Fassadenaufbau nach einem der Ansprüche 1 bis 5, **dadurch gekennzeichnet**, daß die Widerstandsschicht (4) durch einen Vlies mit inkorporiertem Ruß gebildet ist.

7. Fassadenaufbau nach einem der Ansprüche 1 bis 6, **dadurch gekennzeichnet**, daß die Widerstandsschicht (4) aus einem Vlies aus elektrisch leitfähigen Fasern besteht.

8. Fassadenaufbau nach einem der Ansprüche 1 bis 7, **dadurch gekennzeichnet**, daß die Widerstandsschicht (4) innerhalb eines Trägers (5) durch einen Film aus elektrisch und/oder magnetisch leitfähigen Materialpartikeln gebildet ist.

9. Fassadenaufbau nach einem der Ansprüche 1 bis 8, **dadurch gekennzeichnet**, daß zwischen reflektierender Schicht (2) und Widerstandsschicht (4) eine Abstandsschicht (3) durch ein Sandwich-Element gebildet ist.

10. Fassadenaufbau nach Anspruch 9, **dadurch gekennzeichnet,** daß zwischen reflektierender Schicht (2) und Widerstandsschicht (4) eine Abstandsschicht (3) aus mehreren Teilelementen (3**′**, 3**˝**, 3**′′′**) gebildet ist und zwischen den Teilelementen (3**′**, 3**˝**, 3**′′′**) eine zusätzliche Widerstandsschicht (4**′**) und/oder eine stark reflektierende zusätzliche Schicht angeordnet ist.

11. Fassadenaufbau nach einem der Ansprüche 1 bis 10, **dadurch gekennzeichnet,** daß auf die reflektierender Schicht (2) zusätzlich eine Metallfolie oder ein langmaschiges Metallgitter aufgebracht ist.

## Claims

1. Façade design for high-rise buildings having a reflective layer (2) which is applied to the outside of a wall (1), characterized by the following features:
a) an electrical resistance layer (4) having a surface resistance in the range from 300 to 1200 Ω/□ is arranged at a distance of approximately one quarter of the operating wavelength (λ) from the reflective layer (2);
b) the resistance layer (4) is arranged on or in a support (5) which is designed as a façade outer shell and has low transmission attenuation;
c) the support (5) is composed of a building material and
d) a thermally insulating spacer layer (3) is provided between the reflective layer (2) and the resistance layer (4) or the support (5).

2. Façade design according to Claim 1, characterized in that the support (5) is formed from a ceramic material.

3. Façade design according to Claim 1, characterized in that the support (5) is formed by a laminated material made of compressed cellulose surfaces which are impregnated with synthetic resins.

4. Façade design according to Claim 1, characterized in that the support (5) is formed from a fibrated cement building material.

5. Façade design according to one of Claims 1 to 4, characterized in that the resistance layer (4) is formed from a nonwoven with aluminium vapour-deposited on it.

6. Façade design according to one of Claims 1 to 5, characterized in that the resistance layer (4) is formed by a nonwoven with carbon black incorporated.

7. Façade design according to one of Claims 1 to 6, characterized in that the resistance layer (4) is composed of a nonwoven made of electrically conductive fibres.

8. Façade design according to one of Claims 1 to 7, characterized in that the resistance layer (4) within a support (5) is formed by a film made of electrically and/or magnetically conductive material particles.

9. Façade design according to one of Claims 1 to 8, characterized in that a spacer layer (3) is formed by a sandwich element between the reflective layer (2) and the resistance layer (4).

10. Façade design according to Claim 9, characterized in that a spacer layer (3) is formed from a plurality of partial elements (3′, 3′′, 3′′′) between the reflective layer (2) and the resistance layer (4), and an additional resistance layer (4') and/or a highly reflective additional layer are/is arranged between the partial elements (3′, 3′′, 3′′′).

11. Façade design according to one of Claims 1 to 10, characterized in that a metal foil or a long-mesh metal grating is additionally fitted onto the reflective layer (2).

## Revendications

1. Revêtement de façade de bâtiments de grande hauteur avec une couche (2) réfléchissante appliquée sur la face extérieure d'une paroi (1), caractérisé par les caractéristiques suivantes:
a) une couche résistive (4) présentant une résistivité superficielle comprise entre 300 et 1200 Ω/□ est disposée à une distance de la couche réfléchissante correspondant environ au quart de la longueur d'onde (λ) de service;
b) la couche résistive (4) est disposée sur ou dans un support (5) agencé sous forme d'habillage extérieur de façade présentant une faible atténuation de transmission;
c) le support (5) est constitué d'un matériau de construction et
d) une couche d'espacement (3) thermiquement isolante est prévue entre la couche (2) réfléchissante et la couche (4) résistive.

2. Revêtement de façade selon la revendication 1, caractérisé par le fait que le support (5) est constitué d'un matériau céramique.

3. Revêtement de façade selon la revendication 1, caractérisé par le fait que le support (5) est constitué d'une feuille stratifiée formée de panneaux de cellulose comprimés imprégnés de résines synthétiques.

4. Revêtement de façade selon la revendication 1, caractérisé par le fait que le support (5) est constitué d'un matériau en fibro-ciment.

5. Revêtement de façade selon l'une des revendications 1 à 4, caractérisé par le fait que la couche résistive (4) est constituée d'un non tissé métallisé à l'aluminium.

6. Revêtement de façade selon l'une des revendications 1 à 5, caractérisé par le fait que la couche résistive (4) est constituée d'un non-tissé avec du noir de fumée incorporé dans celui-ci.

7. Revêtement de façade selon l'une des revendications 1 à 6, caractérisé par le fait que la couche résistive (4) se compose d'un non tissé formé de fibres électro-conductrices.

8. Revêtement de façade selon l'une des revendications 1 à 7, caractérisé par le fait que la couche résistive (4) est formée, à l'intérieur d'un support (5), par un film constitué de particules de matériau électriquement et/ou magnétiquement conducteur.

9. Revêtement de façade selon l'une des revendications 1 à 8, caractérisé par le fait qu'une couche d'espacement (3) formée par un élément sandwich est disposée entre la couche réfléchissante (2) et la couche résistive (4).

10. Revêtement de façade selon la revendication 9, caractérisé par le fait qu'une couche d'espacement (3) formée de plusieurs sous-éléments (3′, 3′′, 3′′′) est disposée entre la couche réfléchissante (2) et la couche résistive (4) et qu'une couche résistive (4') supplémentaire et/ou une couche supplémentaire à réflexion élevée est disposée entre les sous-éléments (3′, 3′′, 3′′′).

11. Revêtement de façade selon l'une des revendications 1 à 10, caractérisé par le fait qu'un film métallique ou une grille métallique à maille allongées est en outre appliqué sur la couche (2) réfléchissante.
